Europäisches Patentamt

European Patent Office

Office européen des brevets

(11) Publication number:

**0 164 906**
**B1**

(12) # EUROPEAN PATENT SPECIFICATION

(45) Date of publication of patent specification: **23.11.89**

(21) Application number: **85303347.0**

(22) Date of filing: **13.05.85**

(51) Int. Cl.⁴: **B 23 K 35/02,** B 23 K 35/22 //
H05K3/34

(54) Solder composition.

(30) Priority: **14.05.84 US 610078**

(43) Date of publication of application:
**18.12.85 Bulletin 85/51**

(45) Publication of the grant of the patent:
**23.11.89 Bulletin 89/47**

(84) Designated Contracting States:
**AT BE CH DE FR GB IT LI NL SE**

(56) References cited:
**FR-A-2 188 307**
**GB-A-1 590 695**
**GB-A-2 103 980**
**GB-A-2 142 568**
**US-A-3 915 729**

(73) Proprietor: **RAYCHEM CORPORATION (a
Delaware corporation)
300 Constitution Drive
Menlo Park, California 94025 (US)**

(72) Inventor: **Cherian, Gabe
52 Amorok Way
Fremont California 94538 (US)**

(74) Representative: **Jay, Anthony William et al
Raychem Limited Intellectual Property Law
Department Faraday Road
Dorcan Swindon Wiltshire (GB)**

Courier Press, Leamington Spa, England.

**Description**

This invention relates to electrical interconnections, and to methods, devices and materials for forming such interconnections. More particularly, the invention is directed to methods, devices and materials for attaching electronic components, especially chips or chip carrier packages, to each other or to supporting substrates, such as circuit boards.

This invention also relates to British Published Patent Application No. 2,142,568A.

The microelectronics industry is steadily moving toward the use of large chips and chip carrier packages (CCP) which have connection pads on the faces and/or edges. These are generally used where there are limitations with the use of dual inline packages (DIP). The number of connections on the most popular packages can range from 64 to 156. Chip carrier packages can be produced with leads attached (leaded) or they can be leadless.

Leaded CCPs can be soldered directly onto printed circuit boards (PCB) or printed wire boards (PWB). Leadless CCPs can be soldered onto ceramic boards or installed into connectors. However, with glass/epoxy printed circuit boards or printed wire boards, leadless CCPs are usually mounted into connectors which are in turn mounted on the PCBs because of the effect of the different thermal expansion coefficients of the materials involved when subjected to temperature fluctuations. These connectors are complex to manufacture and costly to use. As used herein "electrically conductive elements" is intended to include CCP, PCB, PWB and other electronic or electrical components.

As the CCP technology improves and their reliability increases, more emphasis is directed to soldering these packages directly onto the PCBs to make more use of the board space, and dispensing with the connectors even though the use of connectors permits replacement of faulty CCPs. The cost of conventional connectors relative to the cost of the CCPs can be disproportionately high. This is a strong incentive to use CCPs without connectors.

However, the direct soldering of CCPs on PCBs without the use of connectors is associated with a number of problems. (1) The variation of the surface flatness and non-parallel contours between the CCP and the boards produces varying solder joint heights. (2) The solder will have a tendency to wick out of the joint area into crevises or castellations in the CCP, thus "starving" the joint area. (3) Gold alloying with the solder will produce embrittlement of the "starved" joint. (4) Differential thermal expansion between the CCP and the board will fracture a thin solder joint due to the high shear strains in the joint. (5) Bridging between joints may occur if excess solder is present or if the distance between the joints is small. (6) Solder location tolerances are small and getting smaller yet with increasing packaging density, with a typical connection pad having a width of 0,3 mm (0.012 inches) and a 0,56 mm (0.022-inch) center-to-center spacing. (7) Flux removal from the space between the CCP and the PCB and subsequent inspection thereof. (8) The solder pastes used to attach the CCP will produce loose solder balls which cause electrical problems.

Different solutions have been proposed for the foregoing problems. The proper positioning of a predetermined quantity of solder may be achieved with the use of solder preforms spaced on a carrier or template in the locations corresponding to the points where the solder joints are to be formed. Examples of this technique may be found in U.S. Patents 3,320,658, issued to Bolda et al; 3,396,894, issued to Ellis; 3,472,365, issued to Tiedema; 3,719,981, issued to Steitz; 3,744,129, issued to Dewey; 4,209,893, issued to Dyce et al.; and 4,216,350, issued to Reid.

Dyce et al. and Reid relate more specifically to the use of ring-type solder preforms for the solder connection of pin-type joints. The solder preforms of Dewey are hollow cylinders. Tiedema relates to a flexible carrier ribbon having spaced apertures which receive solder discs to provide a convenient means to handle and transport solder discs.

The Ellis patent discloses a device for simultaneously applying a plurality of solder or other bodies of heat-fusible material, in which the solder bodies are disposed in heat-recoverable cups formed from or positioned on a sheet of material. The cups are spaced to correspond to the location of solder application, and, when heat is applied to the device, the solder melts and the cups recover to a flat configuration, and the recovering cup material forces the solder material out therefrom and into contact with the elements to be soldered.

The Bolda et al. patent provides a thermoplastic carrier sheet onto which a plurality of conductive elements, such as solder preform spheres, are positioned. The individual conductive elements are heated to a temperature which is sufficient to soften the carrier material, but insufficient to deform the conductive elements. During the heating process, the conductive element nestles in the softened thermoplastic material and, upon removal of the heat, the carrier material resolidifies and rigidly supports the conductive elements. When the solder ball carrier assembly is used, heat is applied to melt the solder ball and soften the thermoplastic carrier material, permitting the material to form an insulation between those portions of the electrical conductors not electrically interconnected by the solder elements.

Another approach has been proposed by Bell Laboratories which is developing techniques employing vacuum equipment to pick up and place small solder balls on the underside of the CCPs, and retaining them by using a solid phase bonding method. Additional information may be found in the paper by R. H. Minetti entitled "Solid Phase Solder Bonding for Use in the Assembly of Microelectronic Circuits".

Steitz provides a method of joining solder balls to solder bumps spaced on a semiconductor flip chip by forming an array of solder balls on the tacky side of a pressure-sensitive tape, with the balls being spaced like the solder bumps. The array of solder balls is placed in contact with the solder bumps, and both are then heated to reflow the solder and cooled to fix the contacts after which the tape is removed.

Other examples of solder packs and solder preforms are in U.S. Patent Nos. 3,040,119 to Granzow; 3,535,769 to Goldschmid; 3,750,265 to Cushman; 4,099,615 to Lemke et al., and 4,142,286 to Knuth et al. U.S. Patent No. 3,982,320 to Buchoff et al. discloses electrically conductive connectors constructed from non-conductive and conductive elastomers.

In U.S. Patent No. 3,614,832, Chance et al. form connections between the contacts on a solid-state device and conductive lands on a substrate by placing a decal over the device, the decal having a plurality of conductive strips attached adhesively to a backing sheet. Application of heat and pressure effects bonding of the strips, after which the adhesive is dissolved and the decal removed.

Although the foregoing techniques provide for the correct placement of a predetermined quantity of solder or other suitable joint-forming material, and with the proper dimensioning of the carrier or template, sufficiently small quantities of solder can be positioned on close spacing between centers, these proposals do not address the problem of high shear strains in the solder joints.

As noted above, among the factors considered in forming acceptable electrical connections beween the CCP and the PCB is that the connections must be able to withstand stresses developed due to the effect of temperature fluctuations and the differences in thermal expansion coefficients between the material of the CCP and the substrate or circuit board on which it is mounted. Thus, a CCP may be made of a ceramic material and the circuit board may be made of an epoxy-glass composition, and when subjected to elevated temperatures these elements will expand at different rates, inducing stresses in the connections.

Even if the materials used in the CCP and the circuit board have thermal expansion coefficients which are close in value to minimize the differential expansion effects, heating/cooling cycles which result when power is applied across the CCP induce a temperature differential between the CCP and the PCB to produce stresses in the joints.

It is well known that if the solder joint is formed into a "long" column configuration in which the height of the column is much greater than the diameter or transverse dimension of the joint, less stress is induced in the joint and consequently the joint has greater reliability and longer life.

In the patent to Krall, U.S. No. 3,921,285, a method is described for joining microminiature components to a carrying structure in which the height of the electrical connections may be adjusted during original joining of the component to the carrying structure or in a two-step solder reflow process. The method involves the elongation of the solder joints between the component and its carrier, and is accomplished by the use of a vaporizable material which is either liquid at room temperature or becomes liquid before the solid remelts. A bridge is positioned over the component and the vaporizable material is placed between the bridge and the component surface opposite the surface on which the connections are formed. Heating to achieve soldering causes the material to vaporize, and the combined action of vaporization and surface tension pulls the component closer to the bridge, which in turn elongates the solder joint. Upon cooling the joint remains fixed in its elongated shape.

While Krall provides for elongated solder joints, the device is structurally complex and difficult to use. Specifically, an additional lifting structure is required to operate while the solder is in a molten state. If the motion of the lifting device is too great, or if the solder quantities are not uniform, then some solder joints may be ruptured. Additionally, the lifting structure is an obstacle to cleaning and inspection.

In U.S. Patent No. 4,412,642 to Fisher leadless chip carriers are converted to "cast-leaded chip carriers" by molding high melting point leads to the chip carrier.

Those leads are then soldered to a board by conventional means. Additional examples of methods and devices for interconnecting chip carriers and boards are shown in U.S. Patent Nos. 3,373,481 to Lins et al., 3,680,198 to Wood, 3,811,186 to Larnerd et al. and 4,179,802 to Joshi et al. Joshi et al. uses studs to provide sufficient space under the chip carrier for cleaning. The Krall and Larnerd et al. methods are exemplary of what is known as the "controlled collapse" and "self-stretching" techniques.

Other methods of attaching electronic components, include the pin solder terminals of U.S. Patent No. 3,750,252 to Landman and the collapsed springs of U.S. Patent No. 3,616,532 to Beck. Other examples of soldering chip carriers to boards include U.S. Patent Nos. 3,392,442 to Napier et al. 3,401,126 to Miller et al., 3,429,040 to Miller, 3,355,078 to Smith, 3,859,723 to Homer et al. and 3,614,832 to Chance et al.

The above disclosures address the problem of connections which must be able to withstand the stresses from thermal cycles, none disclose a satisfactory solution which both solves the problem and is suitable for reliable manufacturing processes.

In the above disclosures the solder used is conventional solder which readily flows when molten. The flow is usually of a capillary nature when the solder is on a wettable surface, such as a pre-tinned contact lead. Such conventional solder has a high surface tension tending to make the molten solder form balls when on a non-wettable surface or when positioned on a small area of wettable surface, such as an electrical contact pad, and surrounded by a non-wettable surface, such as epoxy board or ceramic substrate. In some applications a varnish or epoxy material is applied to areas to render them non-wettable by the solder or to enhance the non-wettable character of the area and keep the solder on the desired surface through its inherent surface tension. However, when the mass of the solder is too great for the available wettable surface, the solder will flow across the non-wettable surfaces and may bridge nearby electrical contacts.

Solder has been used in various forms and compositions for a variety of purposes. In U.S. Patent No. 1,281,126 to Bevan a solder material containing metal powder, filings or shavings was used to cover holes. U.S. Patent No. 1,291,878 to Hess discloses a compressed pack of solder filaments combined with flux material and a metal foil cover in a rope or other form convenient for conventional soldering. U.S. Patent No. 1,564,335 to Feldkamp discloses a fuse element made from copper particles compressed into a block and immersed in solder to produce an element which will quickly drop away from the fuse body when the circuit is overloaded. U.S. Patent Nos. 2,431,611 to Durst and 3,163,500 to Konrad et al. disclose incorporating higher melting metals in solder to make a material which will readily flow upon melting and which will form a joint having higher strength when solid. U.S. Patent No. 3,467,765 to Croft discloses a solder containing refractory particles to stabilize the microstructure of the solder composition when solid but which does not interfere with the capillary flow of the solder when liquid. U.S. Patent Nos. 3,605,902 and 3,638,734 to Ault disclose solder which is reinforced internally or externally to prevent cold flow of the solid solder but which will readily flow and collapse upon melting. U.S. Patent No. 3,900,153 to Beerwerth et al. discloses solder containing a small amount of spherical particles to provide spacing between electrical contacts and increase the thickness of the layer of solder in the connection. U.S. Patent No. 4,290,195 to Rippere discloses forming connections in multilayer circuit boards using copper particles wherein the particles are coated with a small amount of solder. British Patent No. 1,590,695 discloses a method of brazing in which high melting point particles such as copper spheres are incorporated in the brazing composition in order to control the minimum clearance of the joint.

Solder pastes, also known as solder creams, are well known and conventionally used to assemble electrical components. Solder pastes comprise conventional solder in a particulate form dispersed in a carrier cream or paste suitable for application to the desired surface at ambient temperatures. Conventional solder pastes and their uses are described by MacKay, *Electronic Packaging and Production*, Feburary 1981, pages 116—132, and by Slattery et al, *Electronics Packaging and Production*, October 1981, pages 146—156. Specialized solder pastes for particular uses are exemplified by Eustice in U.S. Patent 3,915,729 and by Stiegerwald et al. in U.S. Patents 4,248,921 and 4,391,742. The use of solder pastes in the assembly of electrical components, such as by screening or printing, is exemplified by Lim in U.S. Patents 4,270,465 and 4,311,267, by Joffe et al. in U.S. Patent 4,396,140 and in British Patent Application No. 2,103,980. In particular the British Application describes the use of a solder paste that contains high melting point particles for soldering an electrical component to a substrate. The surface tension of the molten solder draws the component and substrate together, and the particles maintain a defined separation between the component and substrate. As with conventional solders discussed above, the solder in the paste readily flows when molten, usually in a capillary nature. Upon melting or reflowing the solder in the solder paste, the paste or cream does not interefere with the flow characteristics of the solder. The paste or cream usually evaporates or runs out around the solder when the solder is reflowed.

In addition to the methods of soldering described above, a method of brazing is described in GB—A—1,590,695 in which the brazing composition contains a quantity of particles that maintain their shape during the brazing composition in order to ensure a minimum joint clearance in the brazed joint.

According to the present invention there is provided a method for forming a connection between preselected points of first and second electrically conductive elements comprising:

applying a preselected point on the first electrically conductive element an amount of solder composition sufficient to form an electrical connection wherein the solder composition comprises solder paste having disposed in the solder paste a filler comprising discrete particles or filaments which are solid at a temperature at which the solder is molten, and which are present in an amount of at least 20% by weight based on the total weight of the filled solder composition, and are of sufficient size and density substantially to maintain the solder in a preformed shape when the solder is molten;

positioning a preselected point on the second electrically conductive element in contact with said amount of solder composition; and

effecting a bond between the electrically conductive elements at the preselected points by reflowing the solder in the solder composition;

the solder substantially maintaining its shape during the reflowing operation.

As used herein the term "solder paste" means any solder paste or cream which contains particulate solder in a binder or carrier, as described in the background section above. The filler according to this invention is a material which prevents a shape of the solder paste from changing substantially in dimensions when the temperature of the solder in the shape of the filled solder paste is raised to or above the melting point of the solder. The filler comprises discrete particles or filaments which are solid at temperatures at which the solder is molten. The filler is present in an amount sufficient to substantially maintain the desired preformed shape of the solder paste when the solder is molten and should not exceed an amount which would interfere with the ability of the solder paste to be spread, printed or applied in a conventional or other desired methods. The filler may be a particulate powder or may be filaments, such as discrete lengths of wire. Preferably the filler is electrically conductive and more preferably is a metal. The amount of filler is generally from about 10% by weight to about 90% by weight based on the total weight of the solder paste-filler mixture, preferably from about 15% to about 80%, more preferably from about 20% to about 60% and most preferably from about 25% to about 40%. The term "filled solder paste" as used herein means a solder paste or cream containing a filler as described above.

An advantage of the present invention is that a connection-forming material, which may have a predefined configuration, can be provided which will sufficiently retain its shape at melting temperatures to form a structural and electrical connection between electrically conductive elements. Furthermore, it is possible in many instances to form a connection that has an increased height dimension and is able to withstand fatigue and repetitive thermal cycling. A plurality of solder-type connections between a plurality of parallel-disposed electrically conductive elements can also be formed simultaneously.

According to the invention filled solder paste is applied to the points where the connection is desired and is preformed into the basic shape desired for the contact or joint forming the connection. For example, the filled solder paste can be shaped into a column type shape on the first element or component, the second element or component placed in a position in contact with the other end of the column shape, and then the solder reflowed. The filler will cause the column to substantially retain its preformed shape when the solder is reflowed and the cream or paste evaporates or otherwise dissipates from the column. The filler used and the amount thereof will depend on the shape desired and, conversely, the shape, e.g. the height of the column, will be limited by the type and amount of filler present, the solder composition used and the type and size of the surface to which the filled solder paste is applied.

This invention also includes variations of the above methods. For example, the shape of filled solder paste can be deposited on the first component and reflowed to form a filled solder shape, such as a column. The cream or paste can be evaporated or dissipated before or during reflowing. Thus, according to another aspect of the invention provides a method for forming an electrically conductive element having a preselected solder point thereon comprising:

applying to a preselected point on the electrically conductive element an amount of a solder composition sufficient to form an electrical connection wherein the solder composition comprises solder paste having disposed in the solder paste a filler comprising discrete particles or filaments which are solid at a temperature at which the solder is molten, and which are present in an amount of at least 20% by weight based on the total weight of the filled solder composition and are of sufficient size and density substantially to maintain the solder in a preformed shape when the solder is molten; and reflowing the solder composition;

the solder substantially maintaining its shape during the reflow operation.

The resulting component having the filled solder shape thereon can then be placed in contact with the second electrical component and the filled solder again reflowed to form the connection between the components. The solder shape substantially retains its shape due to the filler present therein.

Another aspect included in this invention provides a method of building filled solder contact points of increased height by application of filled solder paste to a preselected point on an electrical component, such as by screen printing, reflowing the solder, then applying another layer of filled solder paste and again reflowing. This procedure can be repeated until the desired height of the resulting filled solder contact is achieved.

The fillers useful in this invention include any particulate or filament material which is solid at a temperature at which the solder is molten, which will substantially maintain the preformed shape of the solder when molten and which will not interfere with the application of the solder paste or cream by the desired method. The filler can be electrically conductive or non-conductive but should be solid at a temperature at which the solder being used is molten. It is preferred to use an electrically conductive filler such as a metal. Examples of the preferred metals are copper, iron and nickel. The filler can be in particulate form or filament form. The particles can be a powder and can be irregular shape, plate-like, or spherical. The filaments can be wire pieces.

The invention is now illustrated by the following examples:

Example 1

Filled solder pastes were made according to this invention by mixing a solder paste with a filler. The solder paste was a 63 Sn/37 Pb paste available from Alpha Metals under the identification of "Alpha Micro Cream, 63 Sn/37 Pb, RMA332, 85-2-50". This solder cream contained about 85% by weight solder and 15% rosin cream and the solder particles are about 200 mesh. The filler used was a spherical copper powder sized 170—230 mesh, 0,0635—0,0787 mm (0.0025—0.0031 inch) diameter, available from Atlantic Equipment Engineering. The copper metal powder was mixed at room temperature in various amounts with the solder paste. The percent of copper filler, by weight, with respect to the total mixture weight, varied from 11.5% to 60.9%. The mixtures exhibited the following characteristics:

| % Cu Filler | Workability of filled solder paste | Observation on reflowing |
|---|---|---|
| 11.5 | OK | Formed balls much like conventional solder |
| 29.4 | OK | Substantially retained preformed shape |
| 42.9 | Stiff but spread OK | Substantially retained preformed shape |
| 43.5 | Stiff but spread OK | Substantially retained preformed shape |
| 60.9 | Too stiff to spread | (Not reflowed) |

Example 2

The mixture from Example 1 having 29.4% copper filler, was used to deposit three (3) contact points on a test board, using a stencil, as follows. The stencil was made of a laminated fiberglass reinforced teflon, (teflon coated fiberglass cloth); the thickness of the stencil was about 1,524 mm (0.060 inch). The stencil was positioned on a typical printed circuit test board having rectangular 0,635 by 1,27 mm (0.025 by 0.050 inch) solder pads using 4 registration holes and pins for proper alignment. The holes in the stencil were 0,508±0,0254 mm (0.020±0.001 inch) diameter. Three such stencil holes were filled with the filled solder paste from Example 1 having 29.4% copper powder filler. While the stencil was still on the board, the board and the solder were heated to 215°C in a vapor phase reflow tank. When the board was cooled and the stencil was removed, the filled solder columns were attached to the test board. The height of the columns was about 1,143 mm (0.045 inch). A second board can be placed in contact with the filled solder columns and the solder again reflowed to form connection between the two boards. The filled solder columns will substantially retain their cylindrical shape when the solder is reflowed.

Example 3

The filled solder cream from Example 1 having about 29% copper powder filler was used in this test. The filled solder paste was screen printed on a standard CCMD test board which has 68 rectangular solder pads 0,635 by 1,27 mm (0.025 inch by 0.050 inch) arranged in a square pattern of 17 pads per side and spaced on 1,27 mm (0.050 inch) centers. The screen was a standard screen, as usually used to screen print conventional solder cream, 200 mesh, 46% open area, 0,04064 mm (0.0016 inch) wire diameter 0,08636 mm (0.0034 inch) mesh opening, 0,0889 mm (0.0035 inch) weave thickness, with a 0,0762 mm (0.003 inch) emulsion thickness available from Micro Circuit Engineering Corporation. The openings in the screen were sized and spaced to correspond to the 68 solder pads on the board.

One layer of the filled solder paste was screen printed on the board, then the board placed in the vapor phase reflow tank to reflow the solder. The board was cooled and another layer of filled solder paste was screen printed on top of the first layer, and then reflowed again the same way in the vapor phase reflow tank. The height of the solder points on the solder pads of the test board was 0,2032±0,0508 mm (0.008±0.002 inch) after the second layer was reflowed and cooled.

Successive layers of the filled solder paste were screen printed as above, reflowing and cooling each layer, thus increasing the height of the solder points with each successive layer. After 8 layers, the height of the solder points was 0,3048 to 0,635 mm (0.012 to 0.025 inch) and one bridge between pads had occurred. After 11 layers, the height of the solder points was 0,5842 to 0,9398 mm (0.023 to 0.037 inch) and a second bridge between pads occurred. After 26 layers, the height of the points ranged from 1,016 to 1,651 mm (0.040 to 0.065 inch) with 21 bridges between pads. This example demonstrates that solder interconnect points of increased height can be made using the filled solder cream of this invention. This result was achieved sing a hand operated screen and without optimizing either the filler type and amount or the characteristics of the solder paste. Use of a precision machine operated screen and a filled solder paste optimized for the screen and board used will produce more uniform height of the solder points and will eliminate the bridging between pads. It should also be noted that in this method the last layer of filled solder paste can be screened on the solder points, then the second electrical component placed in contact therewith and the solder reflowed to form the interconnect or the last layer can be reflowed then the second component placed in contact therewith and the solder reflowed to form the interconnect.

The above examples illustrate the practice of this invention from which it will be apparent to one skilled in the art how to select the solder paste, filler and amount of filler to obtain a solder composition according to this invention which can be applied by the desired method and which will substantially retain its preformed shape when the solder is molten. The solder composition can be used and applied in any suitable apparatus or methods, such as those discussed by Slattery et al. referred to above or in the device and method described in British Published Patent Application No. 2,142,568A.

# EP 0 164 906 B1

**Claims**

1. A method for forming a connection between preselected points of first and second electrical components comprising:

applying to a preselected point on the first electrical component an amount of solder composition sufficient to form an electrical connection; wherein the solder composition comprises solder paste having disposed in the solder paste a filler comprising discrete particles or filaments which are solid at a temperature at which the solder is molten, and which are present in an amount of at least 20% by weight based on the total weight of the filled solder composition and are of sufficient size and density substantially to maintain the solder in a preformed shape when the solder is molten;

positioning a preselected point on the second electrical component in contact with said amount of solder composition; and

effecting a bond between the electrical components at the preselected points by reflowing the solder in the solder composition;

the solder substantially maintaining its shape during the reflowing operation.

2. A method for forming an electrical component having a preselected solder point thereon comprising:

applying to a preselected point on the electrical component an amount of a solder composition sufficient to form an electrical connection wherein the solder composition comprises solder paste having disposed in the solder paste a filler comprising discrete particles or filaments which are solid at a temperature at which the solder is molten, and which are present in an amount of at least 20% by weight based on the total weight of the filled solder composition and are of sufficient size and density substantially to maintain the solder in a preformed shape when the solder is molten; and

reflowing the solder composition;

the solder substantially maintaining its shape during the reflow operation.

3. A method according to Claim 2 further comprising:

applying an additional amount of the solder composition on the reflowed solder on the preselected point, and preferably reflowing the additional amount of the solder composition, whereby a filled solder contact point of increased height is formed.

4. A method according to Claim 2 or 3 further comprising:

positioning a preselected point on a second electrical component in contact with the preselected solder point on said electrical component; and

effecting a bond between the electrical component by reflowing the solder.

5. A method according to any one of Claims 1 to 4, wherein the filler in the solder composition is present in an amount of from 20% to 60% by weight based on the total weight of the solder paste-filler mixture, and preferably from 25% to 40%.

6. A method according to any one of Claims 1 to 5, wherein the filler comprises copper, iron or nickel, preferably spherical copper particles.

**Patentansprüche**

1. Verfahren zur Bildung einer Verbindung zwischen vorgewählten Stellen von ersten und zweiten elektrischen Komponenten, umfassend:

Aufbringen einer zur Bildung einer elektrischen Verbindung ausreichenden Menge einer Lotzusammensetzung an einer vorgewählten Stelle auf der ersten elektrischen Komponente wobei die Lotzusammensetzung eine Lotpaste aufweist, wobei in der Lotpaste ein Füllstoff vorgesehen ist, der einzelne Partikel oder Fäden aufweist, die bei einer Temperatur fest sind, bei der das Lot geschmolzen ist, und die in einer Menge von mindestens 20 Gew.-%, bezogen auf das Gesamtgewicht der Füllstoff enthaltenden Lotzusammensetzung, vorhanden und von ausreichender Größe und Dichte sind, um im wesentlichen das Lot in einer vorgeformten Gestalt zu halten, wenn das Lot geschmolzen ist;

Positionieren einer vorgewählten Stelle auf der zweiten elektrischen Komponente in Kontakt mit der Menge der Lotzusammensetzung; und

Herstellen einer Bindung zwischen den elektrischen Komponenten an den vorgewählten Stellen durch Aufschmelzen des Lotes in der Lotzusammensetzung;

wobei das Lot seine Gestalt während des Aufschmelzvorganges im wesentlichen beibehält.

2. Verfahren zur Bildung einer elektrischen Komponente, die darauf eine vorgewählte Lotstelle aufweist, umfassend:

Aufbringen einer zur Bildung einer elektrischen Verbindung ausreichenden Menge einer Lotzusammensetzung an einer vorgewählten Stelle auf der elektrischen Komponente, wobei die Lotzusammensetzung eine Lotpaste aufweist, wobei in der Lotpaste ein Füllstoff vorgesehen ist, der einzelne Partikel oder Fäden aufweist, die bei einer Temperatur fest sind, bei der das Lot geschmolzen ist, und die in einer Menge von mindestens 20 Gew.-%, bezogen auf das Gesamtgewicht der Füllstoff enthaltenden Lotzusammensetzung, vorhanden und von ausreichender Größe und Dichte sind, um im wesentlichen das Lot in einer vorgeformten Gestalt zu halten, wenn das Lot geschmolzen ist; und

Aufschmelzen der Lotzusammensetzung;

wobei das Lot während des Aufschmelzvorganges seine Gestalt im wesentlichen beibehält.

7

3. Verfahren nach Anspruch 2, ferner umfassend:

Aufbringen einer zusätzlichen Menge der Lotzusammensetzung auf das aufgeschmolzene Lot an der vorgewählten Stelle, und vorzugsweise Aufschmelzen der zusätzlichen Menge der Lotzusammensetzung, so daß eine Füllstoff enthaltende Lotkontaktstelle mit größerer Höhe gebildet wird.

4. Verfahren nach Anspruch 2 oder 3, weiterhin umfassend:

Positionieren einer vorgewählten Stelle auf einer zweiten elektrischen Komponente in Kontakt mit der vorgewählten Lotstelle auf der elektrischen Komponente; und Herstellen einer Bindung zwischen den elektrischen Komponenten durch Aufschmelzen des Lotes.

5. Verfahren nach einem der Ansprüche 1 bis 4, wobei der Füllstoff in der Lotzusammensetzung in einer Menge 20 bis 60 Gew.-%, bezogen auf das Gesamtgewicht der Lotpaste-Füllstoff-Mischung, und vorzugsweise in einer Menge von 25 bis 40 Gew.-% vorhanden ist.

6. Verfahren nach einem der Ansprüche 1 bis 5, wobei der Füllstoff Kupfer, Eisen oder Nickel aufweist, vorzugsweise kugelförmige Kupferpartikel.

**Revendications**

1. Procédé de formation d'une connexion entre des points prédéterminés d'un premier et d'un second composants électriques, comprenant:

l'application, à un point prédéterminé du premier composant électrique, d'une quantité de composition de soudure suffisante pour qu'une connexion électrique soit formée, la composition de soudure contenant une pâte de soudure dans laquelle est disposée une charge comprenant des particules ou des filaments séparés qui sont solides à une température à laquelle la soudure est fondue, qui sont présents en quantité au moins égale à 20% du poids total de la composition de soudure chargée et qui ont une dimension et une densité suffisantes pour que la soudure garde pratiquement sa configuration initiale lorsque la soudure est fondue,

le positionnement d'un point prédéterminé du second composant électrique au contact de ladite quantité de composition de soudure, et

la réalisation d'une liaison entre les composants électriques aux points prédéterminés par refusion de la soudure de la composition de soudure,

la soudure gardant pratiquement sa forme pendant l'opération de refusion.

2. Procédé de formation d'un composant électrique ayant un point prédéterminé de soudure à sa surface, comprenant:

l'application, à un point prédéterminé du composant électrique, d'une quantité de composition de soudure suffisante pour qu'une connexion électrique soit formée, la composition de soudure comprenant une pâte de soudure dans laquelle est disposée une charge contenant des particules ou filaments séparés qui sont solides à une température à laquelle la soudure est fondue, qui sont présents en quantité au moins égale à 20% du poids total de la composition de soudure chargée et qui ont une dimension et une densité suffisantes pour que la soudure garde pratiquement sa forme initiale lorsque la soudure est fondue, et

la refusion de la composition de soudure,

la soudure gardant pratiquement sa configuration pendant l'opération de refusion.

3. Procédé selon la revendication 2, caractérisé en ce qu'il comporte en outre l'application d'une quantité supplémentaire de la composition de soudure sur la soudure ayant subi la refusion sur le point prédéterminé, et de préférence la refusion de la quantité supplémentaire de composition de soudure, afin qu'un point de contact de soudure chargé de hauteur accrue soit formé.

4. Procédé selon la revendication 2 ou 3, comprenant en outre;

le positionnement d'un point prédéterminé d'un second composant électrique au contact du point prédéterminé de soudure dudit composant électrique, et

l'exécution d'une liaison entre les composants électriques par refusion de la soudure.

5. Procédé selon l'une quelconque des revendications 1 à 4, dans lequel la charge dans la composition de soudure est présente en quantité comprise entre 20 et 60% du poids total du mélange de charge et de pâte de soudure, et de préférence comprise entre 25 et 40% de ce poids.

6. Procédé selon l'une quelconque des revendications 1 à 5, dans lequel la charge contient du cuivre, du fer ou du nickel et de préférence des particules sphériques de cuivre.

8